# EUROPÄISCHE PATENTSCHRIFT

(11) **EP 0 983 826 B1**
(45) Veröffentlichungstag und Bekanntmachung des Hinweises auf die Patenterteilung: **02.05.2002**
(21) Anmeldenummer: 99116530.9
(22) Anmeldetag: 24.08.1999
(51) Int. Cl.: B25J 1/08, B25J 1/10, H01J 37/20

(54) **Manipulator zur Positionierung von Proben in Apparaturen und Kammern**
Manipulator for positioning probes in apparatuses and in chambers
Manipulateur pour positionner des sondes dans des appareils et dans des chambres

(30) Priorität: 02.09.1998 DE 19839871
(43) Veröffentlichungstag der Anmeldung: 08.03.2000
(73) Patentinhaber: Institut für Festkörper- und Werkstofforschung Dresden e.V., 01069 Dresden (DE)
(72) Erfinder: Möhler, Klaus, 01217 Dresden (DE); Knauff, Oliver, Dr., 52223 Stolberg (DE)
(74) Vertreter: Rauschenbach, Dieter

(56) Entgegenhaltungen:
- US-A- 4 717 309
- EILANDER - FEIJEN - LUITJENS & SUURMEIJER: "Ultrahigh vacuum target manipulator for use in ion channelling and reflection experiments" JOURNAL OF PHYSICS E SCIENTIFIC, Bd. 9, Nr. 10, Oktober 1976 (1976-10), XP002134242
- DURR H ET AL: "A compact three-axis cryogenic ultrahigh vacuum manipulator" JOURNAL OF VACUUM SCIENCE AND TECHNOLOGY: PART A,US,AMERICAN INSTITUTE OF PHYSICS. NEW YORK, Bd. 8, Nr. 1, 1. Januar 1990 (1990-01-01), Seiten 145-146, XP000117279 ISSN: 0734-2101

## Beschreibung

Die Erfindung betrifft einen Manipulator zur Positionierung von Proben in Apparaturen und Kammern, insbesondere in Ultrahochvakuumkammern. Der Manipulator eignet sich für die Anwendung in Apparaturen und Kammern, in denen Werkstoffproben zu untersuchen, zu bearbeiten oder zu beschichten sind.

Es sind bereits Manipulatoren zur Einstellung der Probenposition in Vakuumkammern bekannt. Bei einem dieser Manipulatoren ist es möglich, die Position einer innerhalb der Kammer befindlichen Probe in zwei Bewegungsrichtungen einzustellen (Katalog Vakuum Komponenten der Firma Caburn-MDC, East Sussex, GB, 1997/98, S. 375). Hierbei kann die senkrecht angeordnete scheibenförmige Probe um ihre senkrechte Achse (polare Drehung) und um ihre waagerechte Achse (Azimutdrehung) gedreht werden. Die Probe ist auf einem Probenträger befestigt, der entsprechend betätigt werden kann. Für die Betätigung des Probenträgers zur Azimutdrehung der Probe dient ein Zahnradgetriebe, das über eine Welle von einem Stellmotor angetrieben wird. Die Welle befindet sich dabei in einem in die Vakuum-Apparatur ragenden Führungsrohr, das zur Realisierung der polaren Drehung der Probe mit einer an der Apparatur vorhandenen Stelleinrichtung axial gedreht werden kann.

Nachteilig bei diesem Manipulator ist, dass die Probe lediglich in zwei Richtungen bewegt werden kann und dass keine Möglichkeit für eine Kühlung der Probe vorhanden ist. Darüber hinaus ist auch Positioniergenauigkeit der Probe bei hohen Präzisionsanforderungen unzureichend. Dies resultiert aus der Verwendung des stets mit einem Getriebespiel behafteten Zahnradgetriebes für die Ausführung der Azimutdrehung.

Es ist auch bereits ein Probenmanipulator mit Einrichtungen zur polaren, azimutalen und kippenden Drehung des Probenträgers sowie mit einer Vorrichtung zur Kühlung der Probe bekannt (H. Dürr u.a., A compact tree-axis cryogenic ultrahigh vacuum manipulator, J. Vac. Sci. Technol. A 8(1), Jan/Feb 1990, S. 145/46). Nachteilig ist, dass zur Ausführung der Drehungen bei diesem Manipulator masseintensive Bewegungsübertragungselemente (Schneckenrad, Schnecke, Kugellager) vorhanden sind, die sich nahe der Probe in der gekühlten Zone befinden. Masseintensiv sind funktionsbedingt auch die vorhanden Bewegungszuführungselemente (Wellen, Stäbe). Da über diese Bauelemente eine relativ große Wärmeleitung erfolgt, lassen sich sehr niedrige Probentemperaturen nicht erreichen. Außerdem treten zwischen den in der gekühlten Zone betriebenen Bewegungsübertragungselementen Reibungsprobleme auf.

Der Erfindung liegt die Aufgabe zugrunde, einen Manipulator zur Positionierung von Proben in Apparaturen und Kammern, insbesondere in Ultrahochvakuumkammern, bei dem Einrichtungen zur azimutalen, polaren und kippenden Drehung des Probenträgers sowie eine Vorrichtung zur Kühlung der Probe vorhanden sind, so zu gestalten, dass sehr niedrige Probentemperaturen bis unterhalb 20 K erreichbar sind und eine universelle und präzise Einstellung der Probenposition in den 3 Raumachsen möglich ist.

Diese Aufgabe ist mit einem Manipulator nach Patentanspruch 1 gelöst.

Die Abhängigen Patentansprüche definieren Ausgestaltungen des erfindungsgemäßen manipulators.

Der erfindungsgemäße Manipulator zur Positionierung von Proben in Apparaturen und Kammern, insbesondere in Ultrahochvakuumkammern, ermöglicht in vorteilhafter Weise eine universelle und präzise Einstellung der Position einer Probe in den 3 Raumachsen. Ein besonderer Vorteil dieses Manipulators besteht darin, dass der Kreuzungspunkt der drei senkrecht zueinander stehenden Drehachsen genau in der Probenoberfläche liegt. Im Gegensatz zu dem bekannten Manipulator sind erfindungsgemäß alle Bewegungen voneinander unabhängig, so dass eine Rückstellung einer Größe beim Verändern einer anderen nicht notwendig ist. Vorteilhaft ist weiterhin, dass bei diesem Manipulator ein Probenwechsel unter Untersuchungsbedingungen in situ möglich ist. Da sämtliche Bewegungen ex situ erzeugt werden, ist auch eine computerunterstützte Automatisierung möglich. Vorteilhaft ist auch, dass eine intensive Kühlung der Probe möglich ist, und zwar bis hinunter in den Bereich von unterhalb 20 K. Vorteilhaft ist weiterhin, dass die Kühlvorrichtung ortsfest ist und keine der Bewegungen der Mechanik mitmacht. Die Kühlvorrichtung wirkt direkt auf die Probe, ohne andere Baugruppen mitzukühlen. Dies hat den Vorteil, dass die gesamte Mechanik auf Raumtemperatur bleibt.

Die Erfindung ist nachstehend an Hand eines Ausführungsbeispiels eines Manipulators näher erläutert. Der beschriebene Manipulator dient zur Positionierung von Proben in einer in der Zeichnung nicht dargestellten Ultrahochvakuum-Apparatur. Die den Manipulator darstellenden Zeichnungen zeigen:
- Fig. 1:: eine erste Baugruppe des Manipulators, die als Stelleinrichtung zur Ausführung einer Azimutdrehung einer Probe dient,
- Fig. 2:: eine zweite Baugruppe des Manipulators, die als Stelleinrichtung zur Ausführung einer polaren Drehung der Probe dient,
- Fig. 3:: eine dritte Baugruppe des Manipulators, die als Stelleinrichtung zur Ausführung einer Kippung der Probe dient,
- Fig. 4a:: eine vierte Baugruppe des Manipulators, die zur Kühlung der Probe dient,
- Fig. 4b:: eine Einzelheit der Baugruppe gemäß Fig. 4a,
- Fig. 5:: eine Gesamtdarstellung des Manipulators.

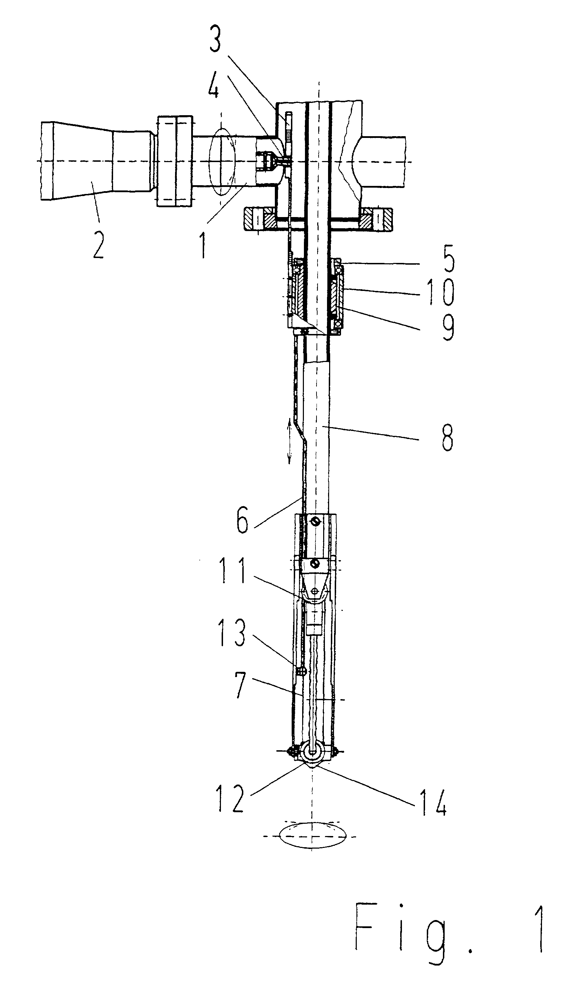

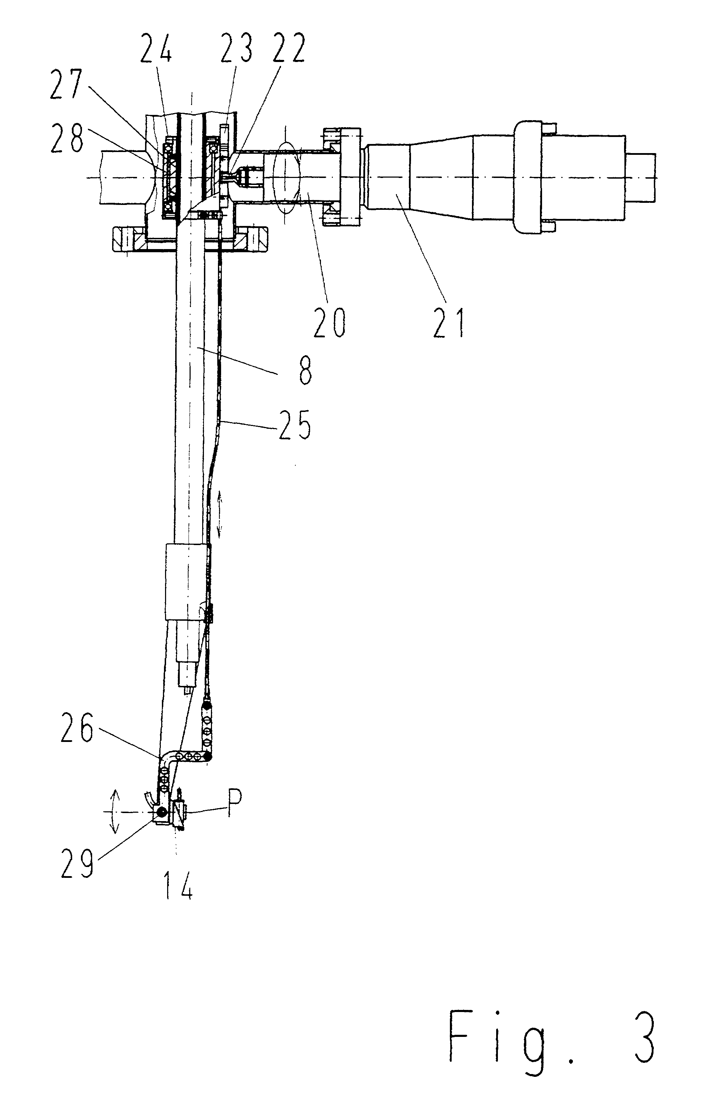

Die in Fig. 1 dargestellte Baugruppe zur Ausführung einer Azimutdrehung der Probe besteht im wesentlichen aus einem Drehstellantrieb 1 mit elektrischem Stellmotor 2, einer Zahnrad 3/Zahnstange 4-Paarung, einem Drehschlitten 5, einer Stellstange 6 und einem Seilzug 7. Der Drehschlitten 5 ist drehbar und in vertikaler Richtung beweglich an einem Halterohr 8 angeordnet und besteht aus einem koaxial um das Halterohr 8 angeordneten Innenrohr 9 und einem um dieses koaxial angeordneten Außenrohr 10. Das Innenrohr 9 ist am Halterohr 8 axial verschiebbar geführt. Das Außenrohr 10 ist am Innenrohr 9 drehbar gelagert. Der Seilzug 7 besteht aus einer Seilschlaufe, die über zwei Seilrollen 11;12 geführt ist. Die Enden der Seilschlaufe sind miteinander unter Zwischenschaltung einer Kompensationsfeder verbunden, wodurch thermische Effekte kompensiert und die notwendige Spannung der Seilschlaufe unter allen Betriebsbedingungen gewährleistet ist. Die am Drehschlitten 5 befestigte Stellstange 6 ist an ihrem unteren Ende mittels einer Klemmverbindung 13 am Seilzug 7 angeklemmt. Die Seilrolle 12 sitzt auf einer für die Azimutdrehung vorhandenen waagerechten Drehachse des Probenträgers 14. Auf dem Probenträger 14 ist in senkrechter Position eine scheibenförmige Probe P befestigt (siehe Fig. 3).

Die Funktionsweise dieser Baugruppe ist folgende: Bei einer Betätigung des Stellmotors 2 wird über die Zahnrad 3/Zahnstange 4-Paarung der Drehschlitten 5 in vertikaler Richtung auf dem Halterohr 8 verschoben. Dadurch wird über die Stellstange 6 der Seilzug 7 betätigt. Dies führt zur Drehung der Seilrollen 11;12, wobei mit der unteren Seilrolle 12 der Probenträger 14 um seine waagerechte Achse gedreht und damit die Azimutdrehung der Probe P ausgeführt wird.

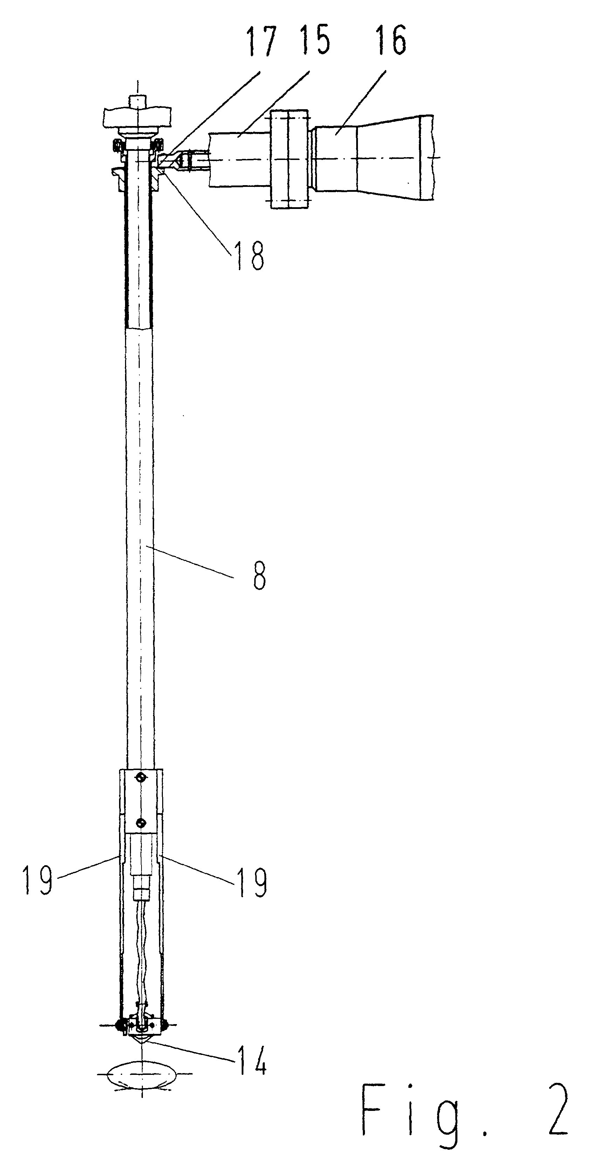

Die in Fig. 2 dargestellte Baugruppe zur Ausführung einer polaren Drehung der Probe P besteht im wesentlichen aus einem Drehstellantrieb 15 mit elektrischem Stellmotor 16, einer Kegelzahnrad-Paarung 17;18, dem Halterohr 8 und zwei Halteleisten 19, die den Probenträger 14 haltern.

Die Funktionsweise dieser Baugruppe ist folgende: Bei einer Betätigung des Stellmotors 16 wird über die Kegelzahnrad-Paarung 17;18 das Halterohr 8 um seine Achse gedreht. Damit wird der mit den Halteleisten 19 gehalterte Probenträger 14 um die senkrechte Achse gedreht und so die polare Drehung der Probe P ausgeführt.

Die in Fig. 3 dargestellte Baugruppe zur Ausführung einer Kippung der Probe P besteht im wesentlichen aus einem Drehstellantrieb 20 mit elektrischem Stellmotor 21, einer Zahnrad 22/Zahnstange 23-Paarung, einem Drehschlitten 24, einer Stellstange 25 und einem winkelförmigen Gelenkhebel 26. Der Drehschlitten 24 ist drehbar und in vertikaler Richtung beweglich am Halterohr 8 angeordnet und besteht aus einem koaxial um das Halterohr 8 angeordneten Innenrohr 27 und einem um dieses koaxial angeordneten Außenrohr 28. Das Innenrohr 27 ist am Halterohr 8 axial verschiebbar geführt. Das Außenrohr 28 ist am Innenrohr 27 quer zu dessen Längsachse drehbar gelagert. Der Gelenkhebel 26 ist um den Lagerpunkt 29 schwenkbar und an seinem unteren Ende mit dem Probenträger 14 fest verbunden.

Die Funktionsweise dieser Baugruppe ist folgende: Bei einer Betätigung des Stellmotors 21 wird über die Zahnrad 22/Zahnstange 23-Paarung der Drehschlitten 24 in vertikaler Richtung auf dem Halterohr 8 verschoben. Dadurch wird über die Stellstange 25 der Gelenkhebel 26 um den Lagerpunkt 29 geschwenkt. Dies bewirkt eine Kippbewegung der Probe P.

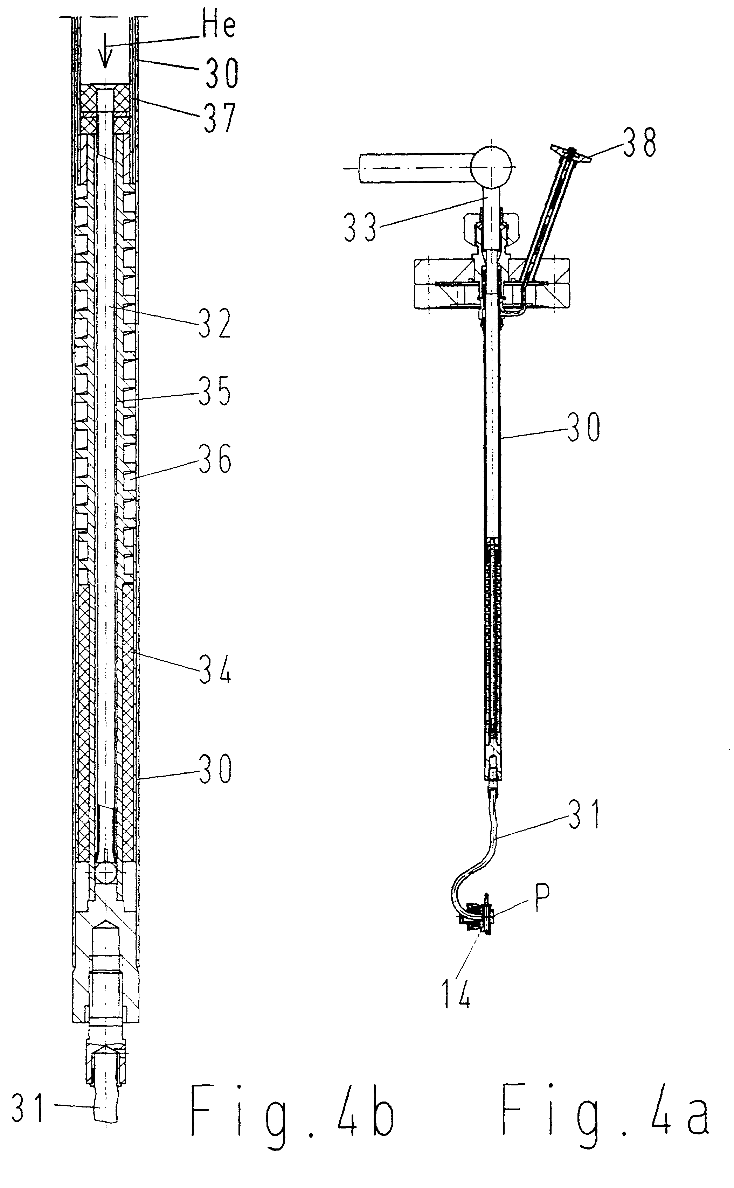

Die in den Fig. 4a und 4b dargestellte Baugruppe zur Kühlung der Probe P besteht im wesentlichen aus einer rohrförmigen Kühleinrichtung 30, die innerhalb des Halterohres 8 (in den Fig. 4a und 4 b nicht dargestellt) zu diesem berührungsfrei angeordnet ist, und aus einem gut wärmeleitfähigen flexiblen Metallstrang 31, der das untere Ende der Kühleinrichtung 30 und den Probenträger 14 miteinander wärmeleitend verbindet. Innerhalb der Kühleinrichtung 30 befindet sich ein Leitungsrohr 32 zum Transport von flüssigem Kühlmittel an das untere Ende der Kühleinrichtung zu dem gut wärmeleitfähigen flexiblen Metallstrang 31. Dieser besteht aus Kupferlitze. Als flüssiges Kühlmittel dient flüssiges Helium He, das über eine Heliumzuführung 33 in die Kühleinrichtung 30 geleitet wird. Für den Rücktransport des Kühlmittels sind innerhalb der Kühleinrichtung 30 um das Leitungsrohr 32 koaxial angeordnet zwei Wärmetauscherrohre 34;35 vorhanden. Das Wärmetauscherrohr 34 im unteren Teil des Leitungsrohres 30 ist ein in Längsrichtung poröser rohrförmiger Wärmetauscher zum Rücktransport des Kühlmittels, der aus gesintertem Kupfer besteht. Oberhalb des Wärmetauscherrohres 34 schließt sich zum weiteren Rücktransport des Kühlmittels das Wärmetauscherrohr 35 an, das an seiner Aussenseite einen spiralförmig verlaufenden Kühlmittelkanal 36 aufweist und aus Kupfer besteht. Am oberen Ende des Wärmetauscherrohres 35 steigt das im Rückfluss befindliche Kühlmittel im Zwischenraum zwischen dem Außenmantel der Kühleinrichtung 30 und einem Innenrohr 37 zu einer Heliumabführung 38 auf und wird dort aus dem Wärmetauscher entnommen. Sie ist somit nicht Teil des UHV-Systems.

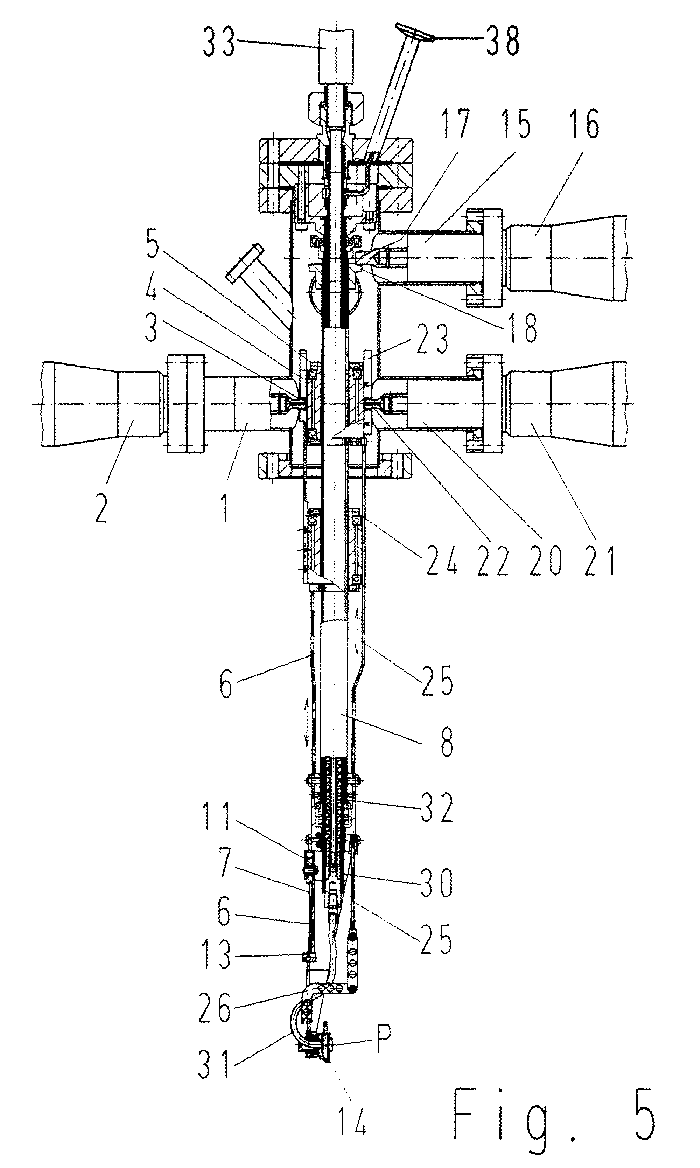

In Fig. 5 ist der Gesamtaufbau des Manipulators, bestehend aus den vorstehend beschriebenen Baugruppen, ersichtlich. Dieser Manipulator ermöglicht eine gleichzeitige, entkoppelte Drehung um die polare, die azimutale und eine dazu senkrechte Achse bei Temperaturen bis unterhalb 10 K.

## Patentansprüche

1. Manipulator zur Positionierung von Proben in Apparaturen und Kammern, insbesondere in Ultrahochvakuumkammern, mit einem probenträger (14), Einrichtungen zur azimutalen, polaren und kippenden Drehung des Probenträgers, sowie einer Vorrichtung zur Kühlung der Probe vorhanden sind, wobei die Vorrichtung zur Kühlung am Probe mittels eines gut wärmeleitfähigen flexibelen Metallstrange (31) mit dem Probeträger (14) Wärmeleitend Verbunden ist, **gekennzeichnet durch** folgende Merkmale:
a) die Stelleinrichtung zur Ausführung der azimutalen Drehung der Probe (P) ist aufgebaut mit einem Drehstellantrieb (1), einer von diesem angetriebenen Zahnrad/Zahnstange-Paarung (3;4), einem damit betätigten ersten Drehschlitten (5), der auf einem senkrecht in der Apparatur angeordneten Halterohr (8) gleitend und drehbar angeordnet ist, und einer am Drehschlitten (5) befestigten Stellstange (6), die mit dem Seil eines Seilzuges (7) verbunden ist, welcher den Probenträger (14) dreht, derart, dass bei einer Betätigung des Drehstellantriebs (1) der Probenträger (14) um die waagerechte Achse gedreht wird,
b) die Stelleinrichtung zur Ausführung der polaren Drehung der Probe (P) ist aufgebaut mit einem Drehstellantrieb (16) und einer von diesem angetriebenen Kegelzahnrad-Paarung (17;18), wobei das eine Kegelzahnrad (18) mit dem Halterohr (8) fest verbunden ist und am Halterohr (8) der Probenträger(14) gehaltert ist,
c) die Stelleinrichtung zur Ausführung der kippenden Drehung ist aufgebaut mit einem Drehstellantrieb (20), einer von diesem angetriebenen Zahnrad/Zahnstange-Paarung (22;23), einem damit betätigten zweiten Drehschlitten (24), der auf dem Halterohr (8) gleitend und drehbar angeordnet ist, einer am Drehschlitten (8) befestigten Stellstange (25) und einem zwischen Stellstange (25) und Probenträger (14) vorhandenen Gelenkhebel (26),
d) die Vorrichtung zur Kühlung der Probe (P) ist mit einer innerhalb des Halterohres (8) zu diesem berührungsfrei und ortsfest angeordneten rohrförmigen Kühleinrichtung (30) aufgebaut, wobei der Metallstrange (31) mit demunteren Ende der Kühleinrichtung (30) wärmeleitend verbunden ist.

2. Manipulator nach Anspruch 1, **dadurch gekennzeichnet, dass** die Drehschlitten (5;24) aus einem koaxial um das Halterohr (8) angeordneten Innenrohr (9;27) und einem um dieses koaxial angeordneten Außenrohr (10;28) bestehen, wobei das Innenrohr (9;27) am Halterohr (8) axial verschiebbar geführt ist und wobei das Außenrohr (10;28) am Innenrohr (9;27) drehbar gelagert ist.

3. Manipulator nach Anspruch 1, **dadurch gekennzeichnet, dass** das Seil des Seilzuges (7) eine über Seilrollen (11;12) geführte Seilschlaufe ist, wobei eine der Seilrollen (12) auf der Achse des Probenträgers (14) zur Ausführung der Azimutdrehung der Probe (P) befestigt ist, und wobei die Enden der Seilschlaufe unter Zwischenschaltung einer Spannfeder miteinander verbunden sind.

4. Manipulator nach Anspruch 1, **dadurch gekennzeichnet, dass** innerhalb der Kühleinrichtung (30) ein Leitungsrohr (32) zum Transport von flüssigem Kühlmittel an das untere Ende der Kühleinrichtung (30) angeordnet ist, und dass für den Rücktransport des Kühlmittels innerhalb der Kühleinrichtung (30) um das Leitungsrohr (32) koaxial angeordnet ein oder mehrere Wärmetauscherrohre (34;35) vorhanden sind.

5. Manipulator nach Anspruch 4, **dadurch gekennzeichnet, dass** im unteren Ende des Leitungsrohres (32) innerhalb der Kühleinrichtung (30) um das Leitungsrohr (32) koaxial angeordnet ein in Längsrichtung poröser rohrförmiger Wärmetauscher (34) zum Rücktransport des Kühlmittels angeordnet ist, der aus einem gesinterten, gut wärmeleitfähigen Werkstoff besteht.

6. Manipulator nach Anspruch 4 und 5, **dadurch gekennzeichnet, dass** oberhalb des porösen rohrförmigen Wärmetauschers (34) innerhalb der Kühleinrichtung (30) um das Leitungsrohr (32) koaxial angeordnet ein Wärmetauscherrohr (35) zum weiteren Rücktransport des Kühlmittels anschließt, das an seiner Außenseite einen spiralförmig verlaufenden Kühlmittelkanal (36) aufweist und aus einem gut wärmeleitfähigem Werkstoff besteht.

## Claims

1. Manipulator for positioning specimens in apparatus and chambers, in particular in ultrahigh-vacuum chambers, having a specimen carrier (14), devices for the azimuthal, polar and tilting rotation of the specimen carrier, and an appliance for cooling the specimen, the appliance for cooling the specimen being connected in a thermally conductive manner to the specimen carrier (14) by means of a flexible metal strand (31) of good thermal conductivity, **characterized by** the following features:
a) the actuating device for carrying out the azimuthal rotation of the specimen (P) is constructed with a rotary actuating drive (1), a gear/rack pairing (3;4) driven by this drive, a first rotary carriage (5), which is actuated by this pairing and is arranged slidably and rotably on a holding tube (8) arranged vertically in the apparatus, and an actuating rod (6), which is attached to the rotary carriage (5) and is connected to the cable of a cable line (7) which rotates the specimen carrier (14), in such a manner that when the rotary actuating drive (1) is actuated, the specimen carrier (14) is rotated about the horizontal axis,
b) the actuating device for carrying out the polar rotation of the specimen (P) is constructed with a rotary actuating drive (16) and a bevel gear pairing (17;18) driven by this drive, one bevel gear (18) being fixedly connected to the holding tube (8) and the specimen carrier (14) being held on the holding tube (8),
c) the actuating device for carrying out the tilting rotation is constructed with a rotary actuating drive (20), a gear/rack pairing (22;23) driven by this drive, a second rotary carriage (24) which is actuated by this pairing and is arranged slidably and rotably on the holding tube (8), an actuating rod (25) attached to the rotary carriage (8), and an articulated lever (26) which is present between actuating rod (25) and specimen carrier (14),
d) the appliance for cooling the specimen (P) is constructed with a tubular cooling device (30) arranged inside the holding tube (8), in a stationary position and not in contact with this tube, the metal strand (31) being connected in a thermally conductive manner to the lower end of the cooling device (30).

2. Manipulator according to Claim 1, **characterized in that** the rotary carriages (5;24) comprise an inner tube (9;27), which is arranged coaxially around the holding tube (8), and an outer tube (10;28), which is arranged coaxially around the inner tube, the inner tube (9;27) being guided in an axially displaceable manner on the holding tube (8), and the outer tube (10;28) being mounted rotatably on the inner tube (9;27).

3. Manipulator according to Claim 1, **characterized in that** the cable of the cable line (7) is a cable loop which is guided over pulleys (11;12), one of the pulleys (12) being mounted on the axis of the specimen carrier (14) in order to carry out the azimuth rotation of the specimen (P), and the ends of the cable loop being connected to one another, with a tensioning spring connected between them.

4. Manipulator according to Claim 1, **characterized in that** a tubular line (32) for carrying liquid coolant to the lower end of the cooling device (30) is arranged inside the cooling device (30), and **in that** one or more heat-exchange tubes (34;35) are arranged coaxially around the tubular line (32) for the purpose of returning the coolant within the cooling device (30).

5. Manipulator according to Claim 4, **characterized in that** a heat exchanger (34), which is tubular and porous in the longitudinal direction, is arranged in the lower end of the tubular line (32), inside the cooling device (30), coaxially around the tubular line (32), for returning the coolant, which heat exchanger consists of a sintered material of good thermal conductivity.

6. Manipulator according to Claims 4 and 5, **characterized in that** a heat-exchange tube (35) for further returning of the coolant is connected above the porous tubular heat exchanger (34), inside the cooling device (30), arranged coaxially around the tubular line (32), which heat-exchange tube (35), on its outer side, has a helically running coolant passage (36) and consists of a material of good thermal conductivity.

## Revendications

1. Manipulateur pour positionner des sondes dans des appareils et dans des chambres, en particulier dans des chambres à ultravide, comprenant un support de sonde (14), des dispositifs pour la rotation azimutale, polaire et en inclinaison du support de sonde, ainsi qu'un agencement de refroidissement de la sonde, l'agencement de refroidissement de la sonde étant raccordé de manière thermoconductrice au support de sonde (14) au moyen d'un lien métallique flexible (31) bon conducteur de la chaleur, **caractérisé par** les caractéristiques suivantes :
a) le dispositif de réglage pour effectuer la rotation azimutale de la sonde (P) est construit avec une commande de réglage rotative (1), une paire de roue dentée/crémaillère (3 ; 4) commandée par celle-ci, un premier chariot rotatif (5) actionné par celle-ci, lequel peur glisser et tourner sur un tube de fixation (8) disposé verticalement dans l'appareil, et une tige de réglage (6) fixée sur le chariot rotatif (5), laquelle est raccordée au câble d'une commande par câble (7), laquelle fait tourner le support de sonde (14) de telle sorte que lors d'un actionnement de la commande de réglage rotative (1), le support de sonde (14) soit tourné autour de l'axe horizontal,
b) le dispositif de réglage pour effectuer la rotation polaire de la sonde (P) est construit avec une commande de réglage rotative (16) et une paire de roues dentées coniques (17 ; 18) commandée par celle-ci, l'une des roues dentées coniques (18) étant raccordée fixement au tube de fixation (8) et étant fixée au tube de fixation (8) du support de sonde (14),
c) le dispositif de réglage pour effectuer la rotation en inclinaison est construit avec une commande de réglage rotative (20), une paire de roue dentée/crémaillère (22 ; 23) commandée par celle-ci, un deuxième chariot rotatif (24) actionné par celle-ci, lequel peut glisser et tourner sur le tube de fixation (8), une tige de réglage (25) fixée sur le chariot rotatif (8) et un levier articulé (26) prévu entre la tige de réglage (25) et le support de sonde (14),
d) l'agencement de refroidissement de la sonde (P) est construit avec un dispositif de refroidissement (30) tubulaire disposé à l'intérieur du tube de fixation (8) fixement et sans contact avec lui, le lien métallique (31) étant raccordé de manière thermoconductrice avec l'extrémité inférieure du dispositif de refroidissement (30).

2. Manipulateur selon la revendication 1, **caractérisé en ce que** les chariots rotatifs (5 ; 24) se composent d'un tube interne (9 ; 27) disposé coaxialement autour du tube de fixation (8) et d'un tube externe (10 ; 28) disposé coaxialement autour de celui-ci, le tube interne (9 ; 27) étant guidé de manière déplaçable axialement sur le tube de fixation (8), et le tube externe (10 ; 28) étant monté rotatif sur le tube interne (9 ; 27).

3. Manipulateur selon la revendication 1, **caractérisé en ce que** le câble de la commande par câble (7) est une boucle de câble guidée sur des poulies (11; 12), l'une des poulies (12) étant fixée sur l'axe du support de sonde (14) pour effectuer la rotation azimutale de la sonde (P), et les extrémités de la boucle de câble étant raccordées l'une à l'autre par l'intermédiaire d'un ressort tendeur.

4. Manipulateur selon la revendication 1, **caractérisé en ce qu'**à l'intérieur du dispositif de refroidissement (30), un tube de conduite (32) pour le transport d'un réfrigérant fluide est disposé à l'extrémité inférieure du dispositif de refroidissement (30), et **en ce que**, pour le retour du réfrigérant à l'intérieur du dispositif de refroidissement (30), on prévoit un ou plusieurs tubes échangeurs de chaleur (34 ; 35) disposés coaxialement autour du tube de conduite (32).

5. Manipulateur selon la revendication 4, **caractérisé en ce qu'**un échangeur de chaleur (34) poreux de forme tubulaire dans la direction longitudinale, pour le retour du réfrigérant, est disposé coaxialement autour du tube de conduite (32) dans l'extrémité inférieure du tube de conduite (32) à l'intérieur du dispositif de refroidissement (30), cet échangeur de chaleur se composant d'un matériau fritté bon conducteur de la chaleur.

6. Manipulateur selon les revendications 4 et 5, **caractérisé en ce qu'**un tube échangeur de chaleur (35) disposé coaxialement autour du tube de conduite (32) se raccorde au-dessus de l'échangeur de chaleur tubulaire poreux (34), à l'intérieur du dispositif de refroidissement (30), pour le retour supplémentaire du réfrigérant, ce tube échangeur de chaleur présentant sur sa face externe un canal de réfrigérant (36) s'étendant en forme de spirale et se composant d'un matériau bon conducteur de la chaleur.
